(19) Europäisches Patentamt

European Patent Office

Office européen des brevets

(11) Publication number: **0 203 614 B1**

# EUROPEAN PATENT SPECIFICATION

(45) Date of publication of patent specification: 24.04.91

(51) Int. Cl.⁵: **H04M 7/06, H04L 12/00**

(21) Application number: **86107363.3**

(22) Date of filing: **30.05.86**

(54) Inter-network connection system.

(30) Priority: **31.05.85 JP 116807/85**

(43) Date of publication of application:
**03.12.86 Bulletin 86/49**

(45) Publication of the grant of the patent:
**24.04.91 Bulletin 91/17**

(84) Designated Contracting States:
**DE FR GB SE**

(56) References cited:

**ALTA FREQUENZA, vol. 44, no. 4, April 1975,
pages 194-210 (88E - 104E). A. BELLONI et
al.: "Routing and internetworking"**

**PROCEEDINGS OF THE 17TH IEEE COMPUTER SOCIETY INTERNATIONAL CONFERENCE
COMPCON FALL; September 5-8, 1978,
Washington, DC, pages 72-79, IEEE, New
York, N.Y., US; J.F. SHOCH: "Inter-network
naming, addressing, and routing"**

**PATENT ABSTRACTS OF JAPAN, vol. 7, no.
292 (E-219) (1437), December 27,1983 & JP-
A-58 166 849**

(73) Proprietor: **FUJITSU LIMITED
1015, Kamikodanaka Nakahara-ku
Kawasaki-shi Kanagawa 211(JP)**

(72) Inventor: **Masuda, Toru
2-7-27, Katase
Fujisawa-shi Kanagawa 251(JP)**
Inventor: **Kamijo, Akinori
7-2-103, Shibokuhon-cho 2-chome Miyamae-
ku
Kawasaki-shi Kanagawa 213(JP)**

(74) Representative: **Lehn, Werner, Dipl.-Ing. et al
Hoffmann, Eitle & Partner Patentanwälte Ar-
abellastrasse 4
W-8000 München 81(DE)**

BRITISH TELECOMMUNICATIONS ENGINEER-ING, vol. 3, no. 4, 1985, pages 255-258, London, GB; D.C. BUTTERWORTH et al: "System X: common-channel signalling - progress on instalation and testing"

JOURNAL OF TELECOMMUNICATIONS NET-WORKS, vol. 2, no. 1, 1983, pages 83-102, Rockville, Maryland, US; D.EINERT et al.: "The SNATCH-Gateway: translation of higher level protocols"

UNTERRICHTSBLAETTER FUER DAS FERN-MELDEWESEN, vol. 37, no. 2, 1984, pages 27-70 Deutsche Bundespost, Hamburg, DE; Das CCITT- Zeichengabesystem Nr. 7

ERICSSON REVIEW, vol. 57, no. 4, 1980, pages 138-148. Stockholm, SW B.A. NILSSON et al.: "AXe 10 - a review"

## Description

The present invention relates to an inter-network connection system in a communication system. In particular, it relates to an inter-network connection system for mutually connecting a plurality of signaling networks using a common channel signaling system.

The common channel signaling system is a system wherein a speech path control signal is transmitted and received between signaling offices through a signal link, independently from a speech path, and commonly utilized by a plurality of speech paths, whereby a connection control of the speech path is carried out. In this system, a common channel signaling network constituted by the signal link is configured independently and separately from a telephone network constituted by the speech path or a data communication network constituted by data communication paths. The connection control of the telephone network and the data communication network is carried out by this common channel signaling network. This signaling system has various advantages, and thus has recently become generally utilized.

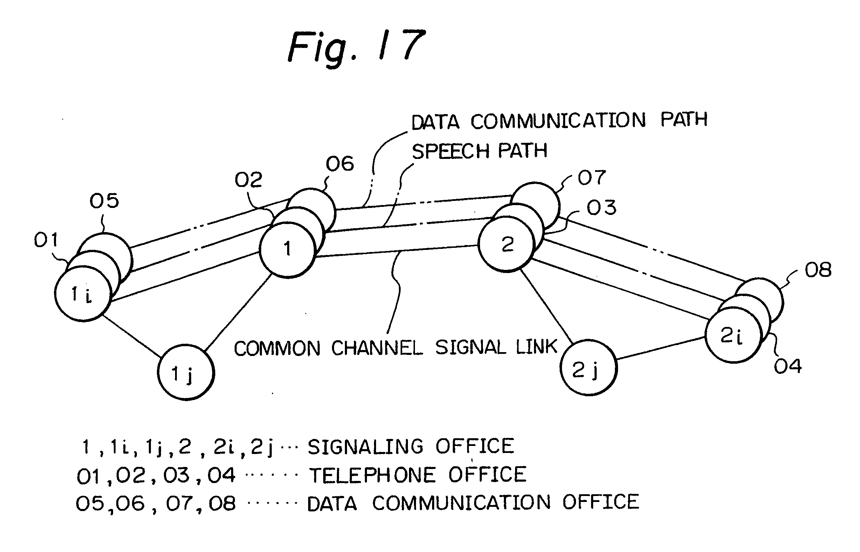

For example, as shown in Fig. 17, a telephone switched network comprising a plurality of telephone offices 01 to 04 and a data communication network comprising a plurality of data communication offices 05 to 08, etc., are interconnected by separate communication lines, i.e., a speech path and a data communication path respectively, so that the communication system is configured thereby.

Usually, a telephone call is carried out by dialling an office code (for example, 01, 02, 03, or 04) assigned to each telephone office, and a data call is carried out by dialling the office code (for example, 05, 06, 07, or 08) assigned to each data communication office, whereby the interconnections between an originating terminal and a destination terminal are carried out, respectively.

The telephone office code and the data communication office code, etc., are determined, respectively, as separate communication networks on the basis of the original numbering plan. Therefore, an efficient transmission of a great amount of the data becomes possible in spite of variations in the communication network and administrative structures thereof, by introducing a common channel signaling system, for example, a CCITT signaling system No. 7 as advised by the CCITT (Internaional Telegraph and Telephone Consultative Committee).

When such a common channel signaling system is adopted, the call connection may be carried out by configuring the common channel signaling network, independently from the telephone switched network and the data communication network, then transmitting information of the destination office to be connected between the signaling offices 1, 1i, 1j, 2, 2i, or 2j on the basis of the independent numbering plan.

In the case when the signaling network is configured by a single administrative structure, the call connection is easily carried out by transmitting the information including an address (destination) information of the terminating signaling office, in the same way as the telephone switching or the data communication.

However, when the signaling network is configured by a plurality of separate signaling networks, an inter-network connection between the separate signaling networks becomes necessary.

The inter-network connection system according to the present invention makes it possible to easily interconnect such common channel signaling networks developed independently by each region, each country, or each manufacturer.

In the past, different signaling networks have been developed for each region, country, or manufacturer, and these signaling networks often have different network structures or administrative structures.

Two inter-network connection systems have been proposed for interconnecting these different common channel signaling networks. In one such system, all of the different signaling networks are integrated so that a new single signaling network containing all of those different signaling networks is configured (see Fig. 14). In another system, at least one signaling office chosen from among the signaling offices in one signaling network is constituted as a gateway office having a dual function of belonging to the other signaling network to be interconnected as well as the self network; and the inter-network connection between the two networks is oarried out through this gateway office (see Fig. 15, Fig. 16).

In carrying out the former system wherein signaling networks are integrated so as to be reconfigured, it is necessary to integrate the signaling office code plan, and the network control procedures in a different way. However, in general, such integration is difficult since, as described above, each signaling network has an originally different network structure or different administrative structure. Further, even if such integration is possible, on such an occasion each signaling office of each of the signaling networks must be provided with signaling network control information of the other signaling network to be connected as well as signaling network control information of the intra-signalling network. As a result, since there is usually a very great amount of such information, the signaling network control information to be kept at each signaling office becomes excessive.

Therefore, for such an integration, a great deal of work must be done for modifying the signaling network control information at each signaling office, and this takes a long time. In particular, since this work must be done at all signaling offices of the signaling network to be integrated, it may take a very long time. Further, as communication services must be discontinued for a correspondingly long time during such modifications, there is a serious deterioration of the quality of the service. Furthermore, if the necessity to modify the signaling network structure of one signaling network among the integrated signaling networks arises after the integration, all of the signaling network control information in all of the integrated signaling networks must be modified. Therefore, the amount of work for maintenance becomes excessive.

In carrying out the latter system wherein the gateway office has a dual function, the realization of such a system is easier in comparison with the aforementioned system. However, the gateway office having a dual function still must be provided with the network control information of both the signaling networks to be interconnected, and when the network structure of the other signaling network must be modified, a great deal of modifying work corresponding to that modification must be carried out.

SUMMARY OF THE INVENTION

It is an object of the present invention to provide an inter-network connection system able to easily carry out the interconnection between signaling networks without a great amount of modifying work.

According to the present invention, there is provided an inter-network connection system for interconnection of a plurality of common channel signalling networks using a common channel signalling system, said connection system comprising: a plurality of common channel signalling networks (A,B) each having an independent code system (numbering system based on a numbering plan) wherein each of said common channel signalling networks comprises one or more signalling offices and in each of said common channel signalling networks, one of said signalling offices is connected to function as a gateway office; and a local signalling network (C) comprising a point to point system including at least one gateway office of each of said common channel signalling networks, and comprising, in each said local signalling network, a code system (numbering system based on a numbering plan) which is different from that of each of said common channel signalling networks, each of said signalling offices including: means for transmitting from one of said common channel signalling networks to another one of said common channel signalling networks, a signal unit comprising user data, an originating office code, and a destination office code, and each of said common channel signalling networks including: an originating office including means for setting the user data, the originating office code and the destination office code in the signal unit and means for sending the signal unit to the gateway office in said one of said common channel signalling networks, the gateway office in said one of said common channel signalling networks including: first changing means for changing in accordance with the user data the destination office code in the signal unit received from said signalling office in said common channel signalling network to which said gateway office belongs, to a gateway office code of said another common channel signalling network which is a second destination office code, and changing the originating office code from said originating office code of said signalling office to an own gateway office code, and for transmitting the signal unit including the second destination information through said local signalling network including both gateway offices; and the gateway office in said another of said common channel signalling networks including: second changing means for changing, in accordance with the user data, the destination office code in a signal unit received from said gateway office in said local signalling office to which said gateway office belongs, to the destination office code which is a third destination office, for changing the originating office code from said gateway office code to an own gateway office code, and for transmitting the signal unit including the third destination information to the destination office.

The article in

BRITISH TELECOMMUNICATIONS ENGINEERING, vol. 3, no. 4, 1985, pages 255-258, London, GB;

D.C. BUTTERWORTH et al.: "System X: common-channel signalling - progress on instalation and testing"

describes the inter connection of two different versions of a common channel signalling system, using the CCITT no. 7 signalling system.

The article in

JOURNAL OF TELECOMMUNICATIONS NETWORKS, vol. 2, no. 1, 1983, pages 83-102, Rockville, Maryland, US;

D. EINERT et al.: "The SNATCH-Gateway: translation of higher level protocols"

describes a gateway system connecting different networks, not being common channel signalling networks, using an independent switching network.

The article in

PROCEEDINGS OF THE 17TH IEEE COMPUTER SOCIETY INTERNATIONAL CONFERENCE COMPCON FALL ;

September 5-8, 1978, Washington, DC pages 72- 79, IEEE, New York, N.Y.,US; J.F. SHOCH: "Inter- network naming, addressing, and routing" describes how names can subsequently be replaced by addresses as a message travels to a distant, connected network.

The inter-network connection system in accordance with the present invention will now be described with reference to the accompanying drawings, in which:

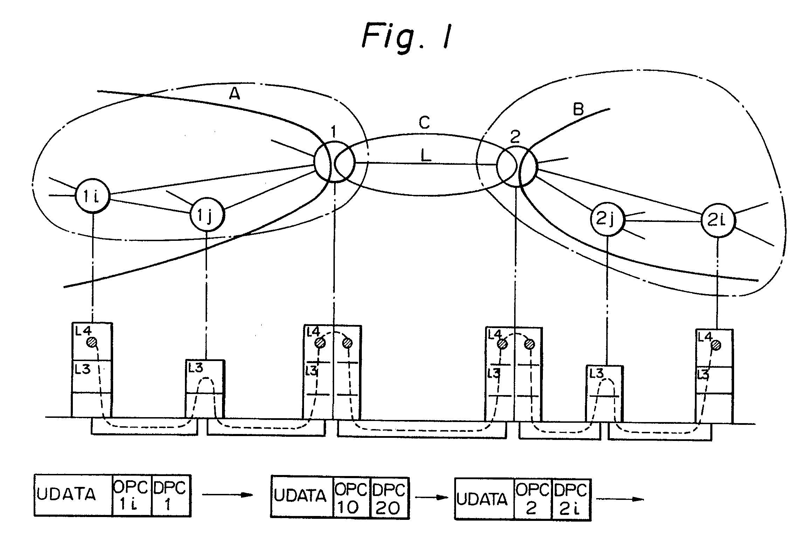

Fig. 1 shows a communication system for carrying out the inter-network connection system according to the present invention;

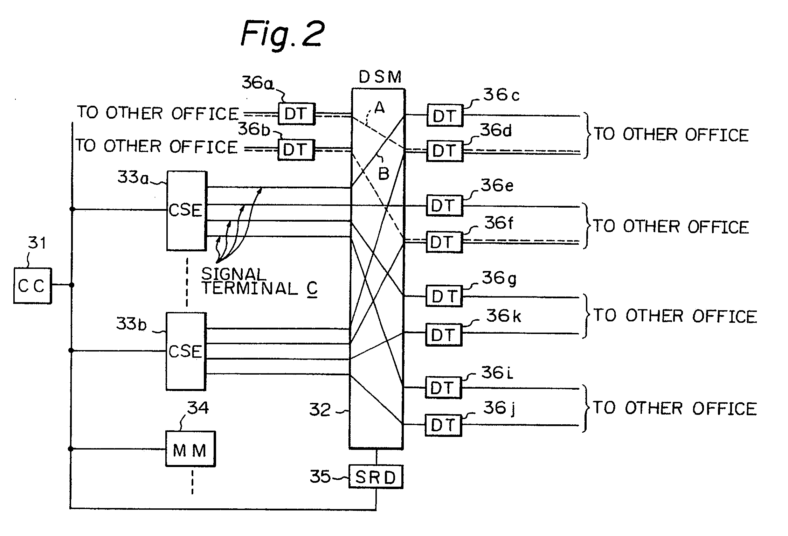

Fig. 2 is a block diagram showing an example of the signalling office of Fig. 1.

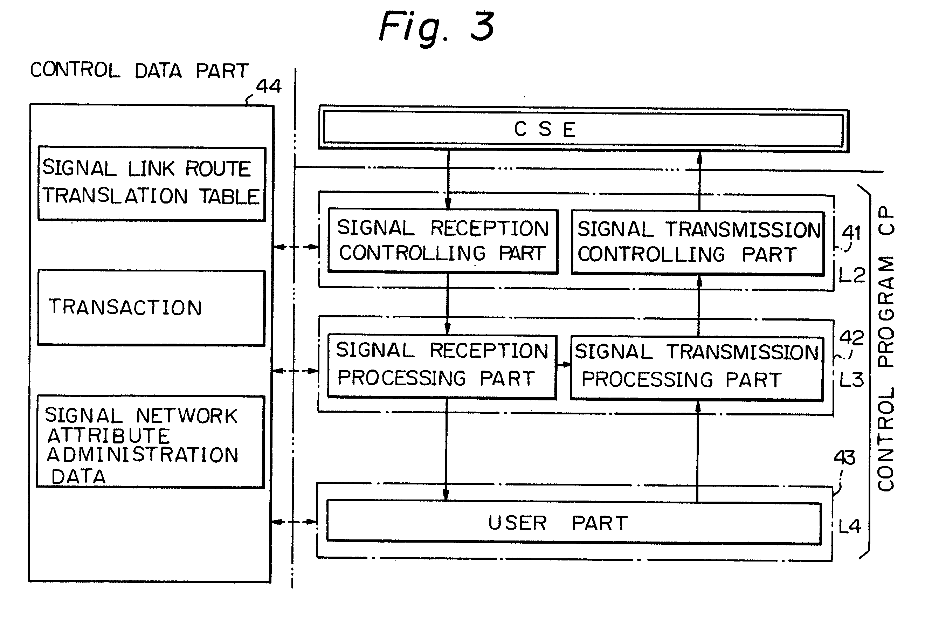

Fig. 3 is an equivalent function block diagram of the main memory in Fig. 2;

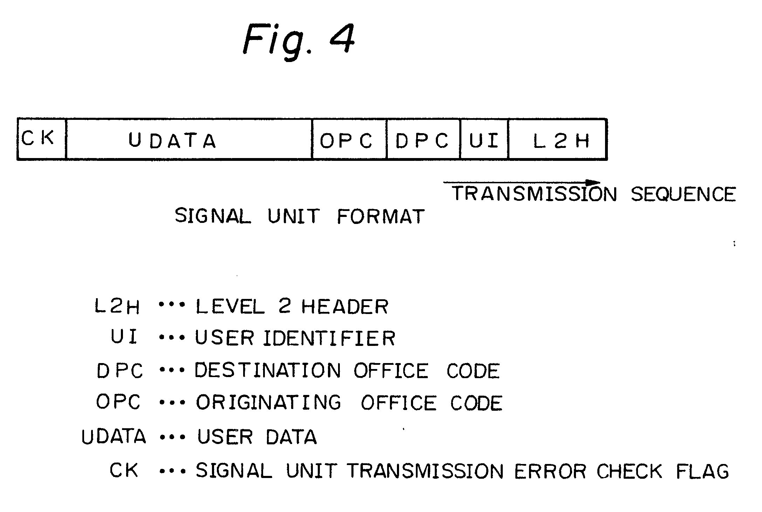

Fig. 4 shows a signal unit for transmitting and receiving between the signalling offices of Fig. 1;

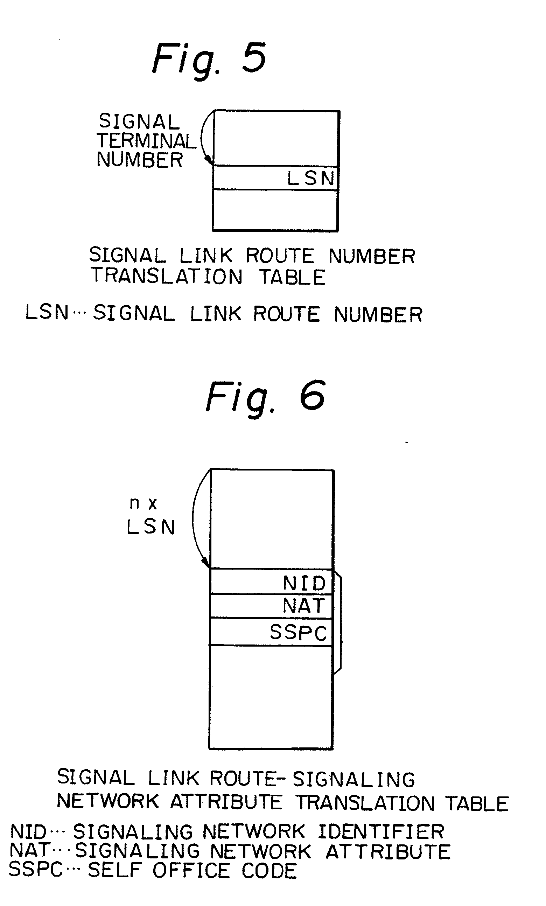

Fig. 5 shows details of the signal link route translation table of Fig. 3;

Fig. 6 to Fig. 8 show various translation tables in the signaling network attribute administration data of Fig. 3;

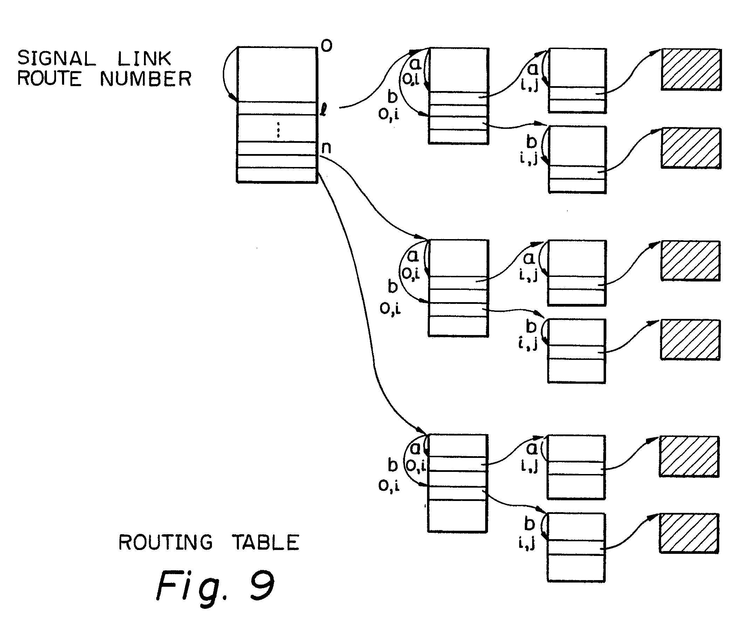

Fig. 9 shows the routing table;

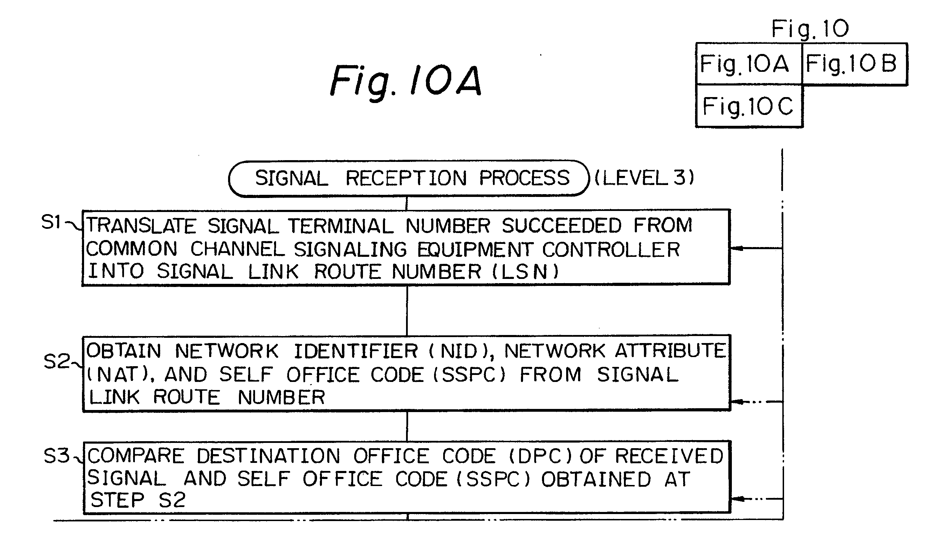

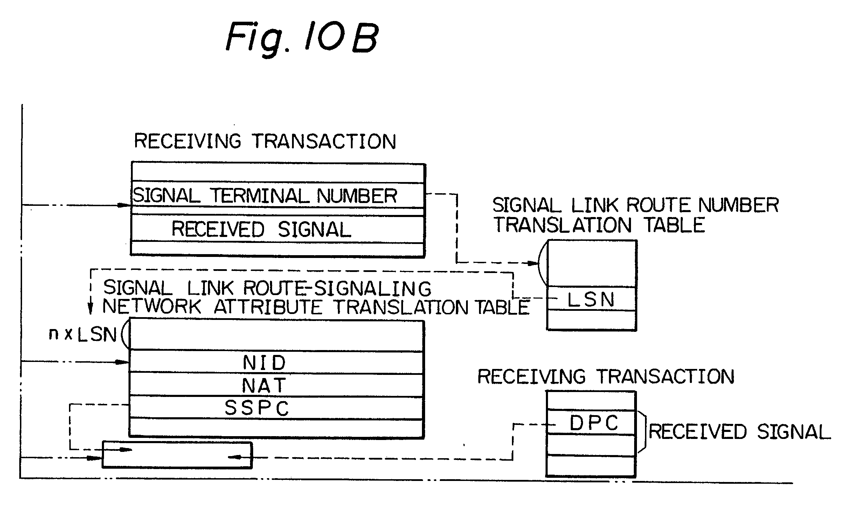

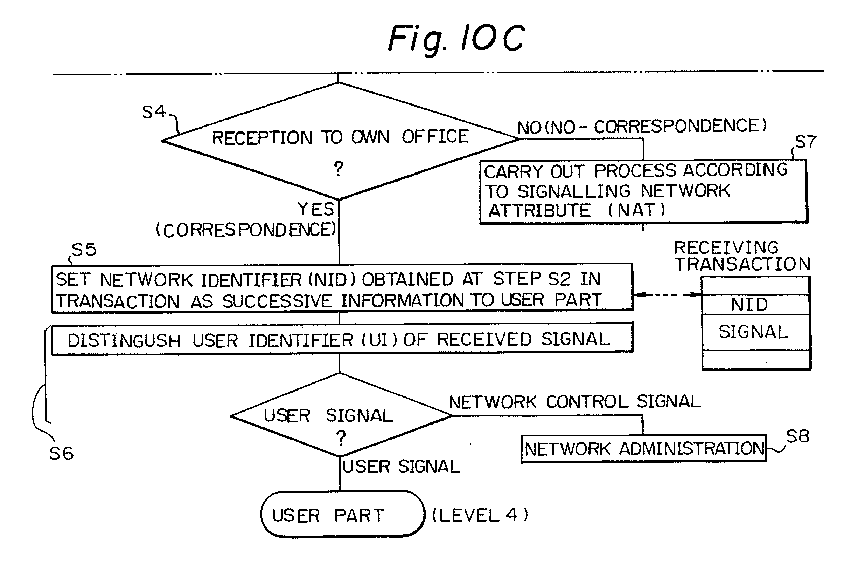

Fig. 10 to Fig. 12 are flow-charts showing the signal transmission and reception procedure carried out at the signaling office;

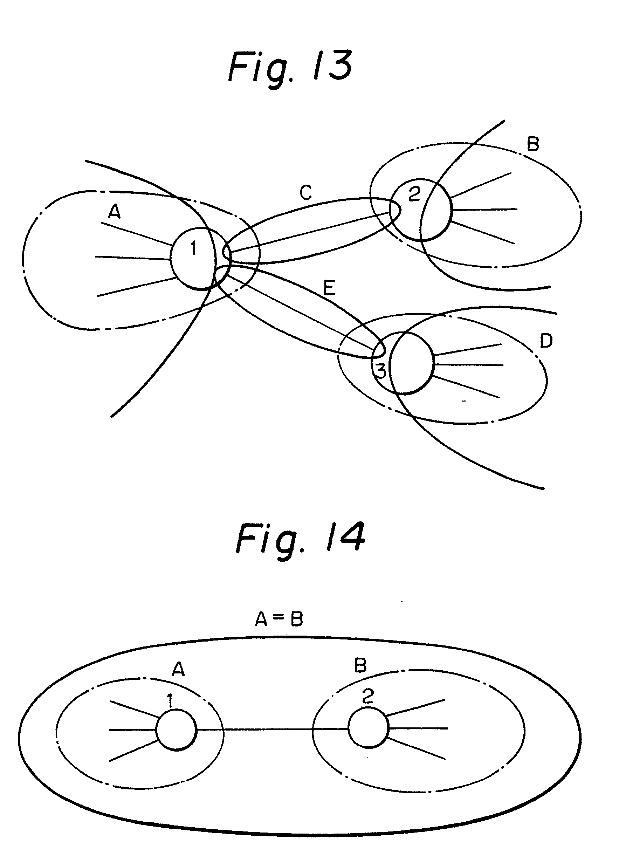

Fig. 13 shows a modification of the present invention,

Fig. 14 to Fig. 16, respectively, show inter-network connection systems of the related art, and;

Fig. 17 is a drawing for explaining the background of the signaling network.

## DESCRIPTION OF THE PREFERRED EMBODIMENTS

A preferred embodiment of the present invention will now be explained with reference to Figs. 1 to 13.

The signaling networks for carrying out the inter-network connection as an embodiment of the present invention is shown in Fig. 1. In Fig. 1, a signaling network A and a signaling network B are networks to be mutually interconnected, and these signaling networks have a different signaling network structure or administrative structure, respectively. However both of these networks use a common channel signaling system. Both the signaling networks A and B comprise a plurality of signaling offices. However, in Fig. 1, only signaling offices 1, 1i, 1j of the signaling network A and signaling offices 2, 2i, 2j of the signaling network B are shown for simplification.

The signaling offices 1 and 2 are gateway offices arbitrarily selected from among the signaling offices of the respective signaling networks A and B, a signal link L is set up between the gateway offices 1 and 2. These gateway offices 1 and 2, and signal link L, constitute a local signaling network C. Therefore, the gateway office 1 belongs to both the signaling networks A and C, and the gateway office 2 belongs to both the signaling networks B and C, whereby the gateway office 1 is provided with control data of the signaling networks A and C as network control information for transferring a signal, and the gateway office 2 is provided with control data of the signaling networks B and C.

An example of a structure of the signaling office in Fig. 1, is shown in Fig. 2. In Fig. 2, 31 is a central controller unit (CC), 32 a digital switch module (DSM), 33a and 33b common channel signaling equipment (CSE), 34 a main memory (MM), 35 a signal receiver and distributor (SRD), and 36a to 36j digital terminals (DT).

The MM 34 stores various control programs such as a common channel control program used for the control of the interconnection within the intra signaling network and between different signaling networks as well as administration data, etc. The execution of these programs is carried out under the control of the CC 31. The transmission and reception of signal unit for the other signaling networks are carried out by the common CSE'S 33a and 33b. The own signaling network and the other signaling network are interconnected by a PCM (pulse code modulation) link set up between the DT's 36c to 36j, and at least one of the time slots (channel) of the PCM link is used as a common channel signal link.

The CSE's 33a and 33b and the time slots in the DT's 36c to 36j are interconnected by a switching operation of the DSM 32. The control information for connecting a speech path A and a signal link B, etc., stored in the MM 34 is transmitted to the DSM 32 through the SRD 35 under the control of the CC 31. The DSM 32 carries out the switching operation by using this information.

An epitomized example of the common channel signal control program and the administration data stored in the MM 34 are shown in Fig. 3. The control program CP may be represented by the equivalent functional blocks. Various functions carried out at each signaling office are represented as function levels L2, L3, and L4. The level L2 represents a signal link control function parts, the level L3 represents signal transfer function parts, and the level L4 represents user function parts, respectively.

The function blocks of the control program of the MM 34 correspond to these function parts. That is, the function blocks comprise a common channel signaling equipment controlling part 41 belonging to the level L2, a signal transfer part 42 of the level L3, and the user part 43, etc. The common channel signaling equipment controlling part 41 comprises a signal reception controlling part and a signal transmission controlling part. The signal transfer part 42 comprises a signal reception processing part and a signal transmission processing part. The user part 43 functions, for example, to carry out a call processing control by analyzing the information of the signal. The control data part 44 comprises signal link route translation table, a transaction, and signaling network attribute administration data, etc.

A format of the signal unit transmitted and received between the own and the other signaling networks is shown in Fig. 4. In Fig. 4, L2H is a level 2 header which is a field for a sequence control and error control of the signal unit at the level 2 in order to transfer the signal unit. UI is a user identifier which is a representation for distinguishing, for example, a telephone user part or a data user part. DPC is a destination office code, OPC an originating office code. UDATA is user data comprising, for example, a telephone call destination number, a telephone call originating number, a speech path number, and a telephone subscriber's number. CK is a signal unit transmission error check flag for detecting a bit error at the time of transmissionof the signal unit.

A detailed structure of the signal link route translation table in the control data of Fig. 3 is shown in Fig. 5, and examples of detailed structures of the signaling network attribute administration data are shown in Fig. 6 to Fig. 8. Figure 5 shows a signal link route number translation table, which is used for looking up the signaling network attribute, etc., by using the number of the signal terminal C in Fig. 2 as an index when the signal is input.

Figure 6 shows ·a signal link route-signaling network attribute translation table. This table is used to look up the signaling network attribute, etc., by using the signal link route number as an index. In Fig. 6, NID is a signaling network identifier, NAT is a signaling network attribute, and SSPC is an own office code. The signaling network identifier NID is an indication for distinguishing the signaling network, for example, to distinguish whether the signaling network in Fig. 1 is A, B, or C. The signaling network attribute NAT is an indication for indicating the signaling network configuration, for example, to indicate whether the network is a point-to-point system signaling network such as the signaling network C, or a signaling network which carries out the routing process such as the signaling network A and B.

Note, the routing is a process by which the existence and the availability of the signal route to the directed signaling office is checked on the basis of a routing table administrated at each signaling office, as shown in Fig. 9. The routing table contains information by each number of the signaling link route, which information relates to the signaling office for transmitting and receiving the signal to or from the signaling office within the intra signaling network on the signal link route. By this information, the existence of the signal route to the directed signaling office, the status of the possibility of access to the signaling office, and the status of the availability of the signal route, etc., can be administrated. Figure 9 shows an example of the table structure of the routing data for the signaling offices having the signaling office codes a and b respectively.

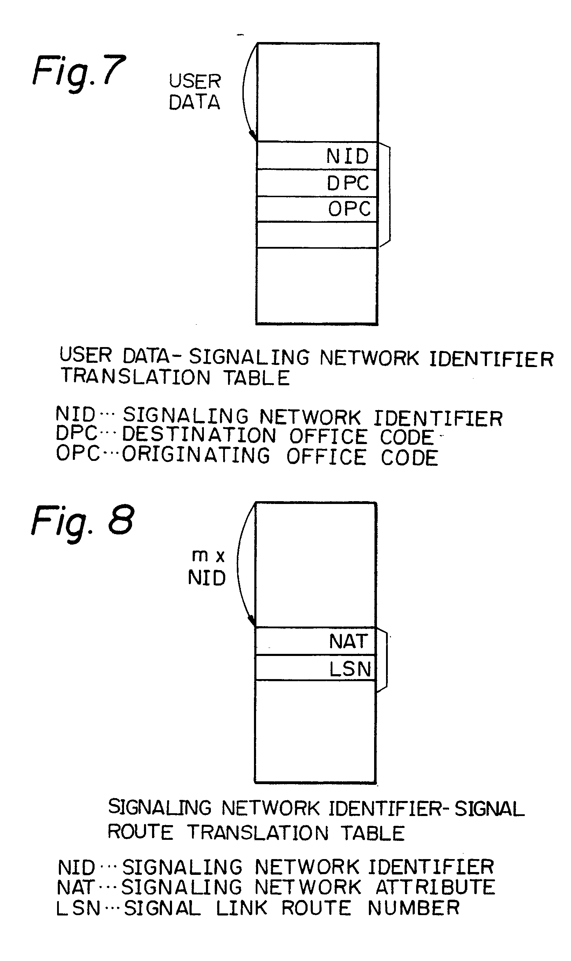

Figure 7 shows a user data-signaling network identifier translation table. This table looks up the network identifier etc. by using the user data UDATA in the signal unit as an index. The contents are, the signaling network identifier NID, the destination office code DPC, and the originating office code OPC. Figure 8 shows a signaling network identifier-signal link route translation table. This table looks up the signaling network attribute NAT and the signal link route number LSN, etc., from the signaling network identifier.

The operation of the inter-network connection in the signaling network constituted as described above will be explained hereinafter with reference to Fig. 10 to Fig. 12.

Assuming that the signal is transferred from an arbitrary signaling office 1i in one signaling network A to a signaling office 2i in the other signaling network B in Fig. 1, and a speech path (not shown) is set up therebetween. The signal transfer is carried out by transmitting the signal from the signaling office 1i through the signaling office 1j and the gateway office 1 in the signaling network A, the local signaling network C, and the gateway office 2 and the signaling office 2j in the signaling network B to the signaling office 2i.

In the middle portion of Fig. 1, the function levels of the process for carrying out the transfer of the signal at each signaling office that the signal passes through at the time of the signal transfer are shown. In the lower portion of Fig. 1, the schematic signal units at each signaling network are shown.

First, when a call from a user at the signaling office 1i of the signaling network A to a user at the signaling office 2i of the signaling network B is generated, the signaling office 1i analyzes the content of the user data by means of the user part of the level L4. As a result of the analysis, if the call originating signal is distinguished as being directed to the signaling network B, then that signal is transmitted to the gateway office 1 in the signaling network A. At the time of transfer of the signal, if necessary, the signal is transferred to the gateway office 1 via the signaling office 1j. Since the control operations in the signaling offices 1i and 1j are fundamentally the same as the operation of the gateway office described later, a detailed explanation of the operation is omitted here.

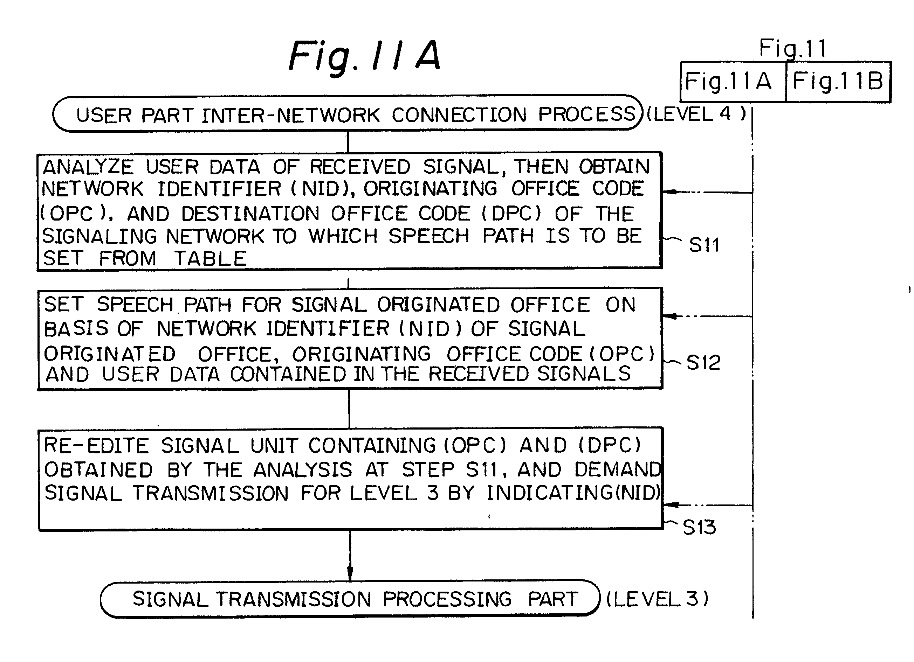

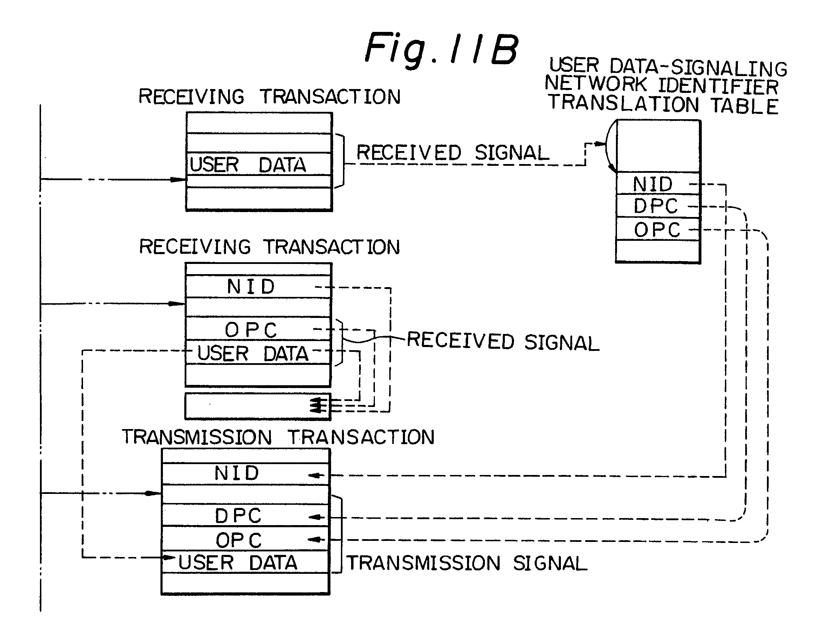

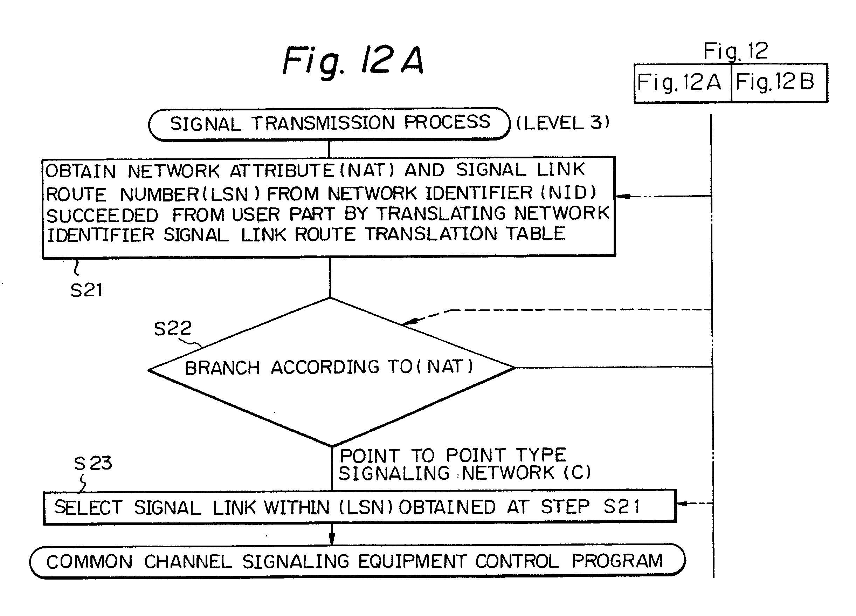

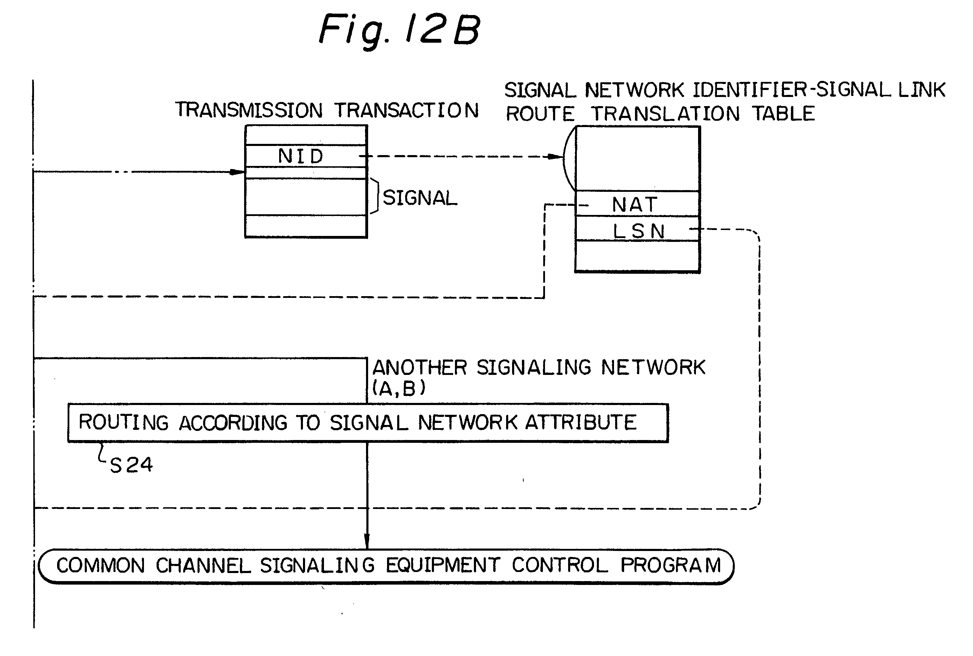

When the signal generated at the signaling office 1i is simply transferred through the signaling office 1j and received at the gateway office 1, the gateway office 1 processes the received signal in accordance with the procedure shown in the flow charts of Fig. 10 to Fig. 12. Figure 10 is a flow chart showing a procedure at the signal reception processing part 42 in Fig. 3 of the level L3. Figure 11 is a flow chart showing the procedure at the user part 43 in Fig. 3 of the level L4, and Figure 12 is a flow chart showing the procedure at the signal transmission processing part 42 in Fig. 3 of the level L3.

Schematically, the process in the gateway office 1 is as follows. That is, after setting up the speech path between the signal generating office 1i and the gateway office 1 within the signaling network A, the transmission of the signal toward the gateway office 2 in the signaling network C is demanded, and the gateway office 1 transmits the signal after confirming that transmission of the signal toward the gateway office 2 is possible. A detailed explanation of this operation will be given hereinafter.

In the gateway office 1, the received signal in Fig. 2 is input to one of the signal terminals of the CSE 33a or 33b through one of the DT's 36a to 36j and the DSM 32, whereby the CC 31 carries out the control procedure shown in Fig. 10 by using the data of the MM 34. That is, the signal terminal number of the CSE 33a or 33b to which the signal is input and the content of the received signal are stored in the receiving transaction. At the same time, the signal terminal number is translated into the signal link route number by using the signal link route number translation table of Fig. 5 (step S1), further, the signaling network identifier NID, the signaling network attribute NAT, and the self office code SSPC are obtained from the signal link route number using the signal link route-signaling network attribute translation table of Fig. 6. (step S2).

Next, the destination office code DPC contained in the received signal and the self office code SSPC obtained at the step S2 are compared (step S3), thereby distinguishing whether the received signal is destined for the self office or not (step S4). When the received signal is destined for the self signaling office, the codes correspond, and when destined for an other signaling office, the codes do not correspond. When there is no correspondence, the receiving office simply transfers the signal to the other signaling office, and a transfer process corresponding to the signaling network attribute NAT is carried out at the level L3 without carrying out the process of the level L4. This process corresponds to the process at the signaling office 1j.

When it is determined that the received signal destined for the own signaling office, the process of the level L4 is carried out for the received signal. However, prior to that process, the signaling network identifier NID obtained at step S2 is stored in the receiving transaction as the successive information to the user part (step S5). After that, it is determined whether the received signal is the user signal from the user or not (step S6). When it is identified as a signal other than the user signal, for example, a network control signal, the network administration, etc., is carried out without going to the level L4 process (step S8).

When the received signal is identified as the user signal, the inter-network connection process of the level 4 by the user part 43 shown in Fig. 11 is carried out. In the user part 43, the user data, such as a telephone number, in the received signal is analyzed, and using the user data-signaling network identifier translation table shown in Fig. 7, the signaling network identifier NID, originating office code OPC, and destination office code DPC, etc., of the signaling network to which the speech path is to be set up are obtained from the user data (step 11). In the present example, the signaling network identifier NID indicates the signaling network C, the originating office code OPC indicates the signaling office 10, which is the code of the gateway office 1 relating to the signaling network C, and the destination office code DPC indicates the signaling office 20 which is the code of the gateway office 2 relating to the signaling network C.

Next, the speech path is set up between the signal originated office 1i and the gateway office 1 on the basis of the signaling network identifier NID of the signal originating office (here, the signaling network A), the originating office code OPC in the received signal (here, the signaling office 1i), and the user data UDATA in the received signal, etc, (step 12).

Subsequently, the signal unit containing the origination office code OPC, and the destination office code DPC, which are obtained as a result of the analysis, as well as the user data of the received signal, is re-edited and stored into the transmission transaction memory, then, indicating the network identifier NID which is obtained at step S11, transmission of the signal is demanded for the signal transmission processing part (steps 13). That is, the edited signal unit comprises the origination office code OPC indicating the signaling office 10, and the destination office code DPC indication, the signaling office 20 which belong to network C, etc.

In the signal transmission processing part 42 in Fig 3, in order to carry out the transmitting process of the signal, the signaling network attribute NAT and the signal link route number LSN are obtained by means of translating the signaling network identifier NID (signaling network C) succeeding the user part 43 using the signaling network identifier-signal route translation table (step S21). Then, the procedure is branched by the signaling network attribute NAT. In this example, the signaling network attribute NAT is the signaling network C of the point-to-point type, the procedure proceeds to step S23 wherein the signal link within the signal link route number LSN obtained at step S21 is selected, and the transmission control operation is demanded for the common channel signaling equipment controlling program. On the other hand, when the signaling network attribute NAT is such as networks A or B, which need the routing process, the procedure goes to step S24 wherein the routing process according to the signaling network attribute is carried out and the transmission controlling operation is demanded for the common channel signaling equipment controlling program.

According to the operation described above, the signal generated at the signaling office 1i reaches the gateway office 1 of the signaling network A so that the speech path is set up, and then the signal is transferred in the signaling network C from the gateway office 1 (10) toward the gateway office 2 (20).

In the gateway office 2, a process the same as that of the gateway office 1 is repeated. That is, after the confirmation at the user part 43 that the received signal is destined for the signaling network B by analyzing the user data, the speech path is set up between the gateway office 1 (10) and the gateway office 2 (20), and then the transmission of the signal toward the signaling office 2i in the signaling network B is demanded for the signal transmission processing part 42. In this case, the signaling network identifier NID is the signaling network B, the originating office code OPC is the signaling office 2, and the destination office code DPC is the signaling office 2i. Then, the signal unit containing this information is re-edited at the gateway office 2 and transmitted to the aimed signaling office 2i. Since the connection control procedure hereafter is the same as that of the connection control procedure of the prior art, an explanation thereof will be omitted.

In the above description, the inter-network connection from the signaling network A to the signaling network B is described. The inter-network connection from the signaling network B to the signaling network A is obviously exactly the same, and it is clear that the connection between signaling offices in each signaling network need not always go through the tandem offices 1j and 2j.

As described above, when tandem offices 1j and 2j are constituted as the signaling office only and not the speech path control office, the speech path is set up in sequence from 1i via 1 (10) and 2 (20) to 2i. The signaling network A containing signaling office 1i, 1j, and 1, and the signaling network B containing the signaling offices 2, 2j, and 2i are interconnected through the signaling network C newly configured by gateway offices 1 and 2 having a dual function and belonging to the signaling networks A and B, respectively. As a result, it is sufficient for each signaling office in the signaling network A to hold only the data for judging that the generated call is the signal destined for the signaling network B and the control data for transferring that signal to the gateway office 1 with regard to the inter-network connection between the signaling networks A and B. It also is sufficient that the gateway office 1 holds only the data for connecting between signaling offices in the signaling network A and the data for connection to the gateway office 2 in the signaling network C, and therefore, the connection data for the signaling network B is not necessary.

As a result, the separation of the signaling networks to be connected is achieved, and at the same time, the number of contact points to which both signaling networks must be connected is decreased due to the local signaling network C, which absorbs the difference of the signaling network structure to be connected and the differences of the detailed connection procedure and the network administration procedure, such as a recent change procedure, etc., whereby the network design such as a network code design can be carried out at individual networks independently. Therefore, the modification of the network structure of one signaling network does not influence the other signaling networks. Further, the data to be held at each signaling offices for inter-network connection is limited and only a small amount, thereby the administration of variable data for the signal transfer, for example, the data of the administration and supervisory, etc. for the status variation of the route become unnecessary in most cases.

It is clear from Fig. 9 that it is sufficient if only a small amount of data is held by each signaling office. That is, it can be easily discerned that, in the system as shown in Fig. 14 wherein all signaling offices are integrated into a single signaling network, there exist a problem in that the amount of data to be held at each signaling office becomes excessive. On the other hand, in the system of Fig.

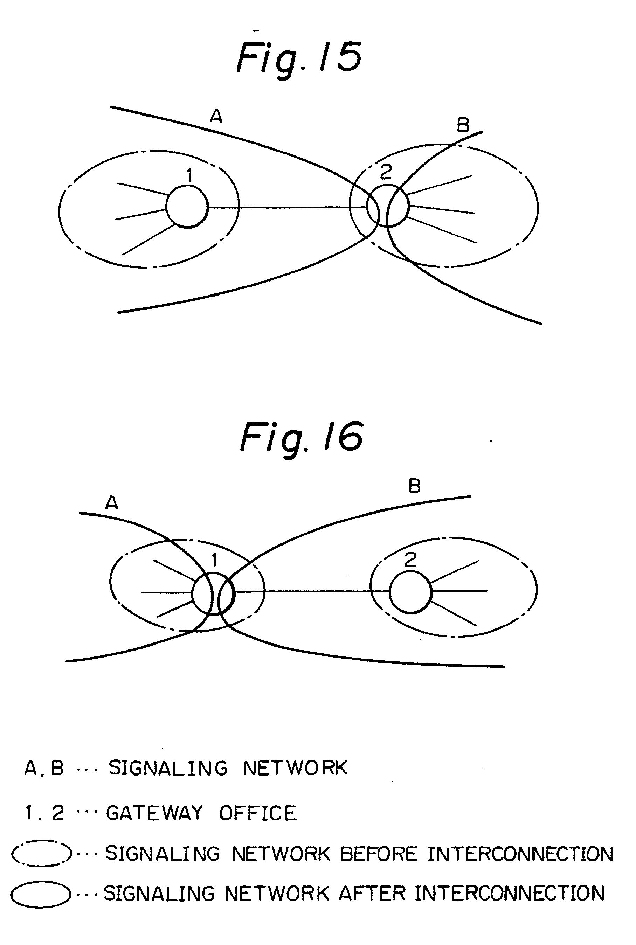

15 or Fig. 16, it is enough for only the gateway office to hold the data of each signaling office in the other signaling network in addition to the data of each signaling office in the own signaling network. However, regarding the gateway office, the amount of data to be held also becomes excessive, and in order to cope with an increase in the signaling office of the other network and the modification of the signaling office code, a complicated modification procedure is similarly necessary.

On the contrary, in the inter-network connection system according to the present invention described above, it is sufficient if the signaling offices in the signaling network A hold the data of the signaling office in the signaling network A, as in the prior art: Also, it is sufficient for signaling offices in the signaling network B to hold the data of the signaling office of the signaling network B, as in the prior art. Further, it is sufficient for the gateway office to hold only the data of the newly configured signaling network C in addition to the data of the own signaling network (network A or network B). Therefore, according to the present invention, it is clear that an effect exists whereby the amount of data is decreased and one signaling network has very little influence with regard to the modification of the other signaling network, in comparison with the prior art system.

Various modifications are possible in carrying out the present invention. For example, as shown in Fig. 13, the gateway office 1 of the signaling network A can be included in not only the local signaling network C including the gateway office 2 of the signaling network B but also a new local signaling network E including a gateway office 3 of a different signaling network D. That is, the system may be constituted so that the gateway office 1 has a triple function and belongs to the signaling networks A, C, and E, whereby an inter-network connection between the signaling networks A, B, and D, becomes possible. Of course, the gateway office 1 may further belong to many other signaling networks, and the gateway offices 2 and 3 may belong to numerous signaling networks. Further, for example, the local signaling network of the gateway office 1 for the signaling network B is not limited to the local signaling network C. It is possible to constitute the local signaling network C' between the gateway office 1 and the different gateway office 2' in the signaling network B. Thus, as the number of signaling networks to be connected increases, the effect of reducing the amount of data and the effect of preventing an influence on the other signaling network due to a modification of the structure of the signaling network, which are obtained by the present invention, become even more remarkable.

According to the present invention, it is not necessary for the signaling offices of each signaling network to hold the network control data of all signaling offices in the other signaling network to be connected, in order to carry out the inter-network connection, and thus the amount of work for realizing the interconnection between signaling networks does not become excessive, and therefore the inter-network connection is easily realized. Each signaling network becomes independent of the other signaling network by placing the local signaling network therebetween, whereby an influence from modification of the network structure in one signaling network over the other signaling network is prevented so that the amount of work accompanying the modification of the network structure at each signaling network after the establishment of the inter-network connection can be kept to a minimum. Further the network design such as the office code design are made possible for individual networks, and thus the degree of freedom in design at each signaling network can be increased.

## Claims

1. An inter-network connection system for interconnection of a plurality of common channel signalling networks using a common channel signalling system, said connection system comprising:

   a plurality of common channel signalling networks (A,B) each having an independent code system (numbering system based on a numbering plan) wherein each of said common channel signalling networks comprises one or more signalling offices and in each of said common channel signalling networks, one of said signalling offices is connected to function as a gateway office; and

   a local signalling network (C) comprising a point to point system including at least one gateway office of each of said common channel signalling networks, and comprising, in each said local signalling network, a code system (numbering system based on a numbering plan) which is different from that of each of said common channel signalling networks, each of said signalling offices including:

   means for transmitting from one of said common channel signalling networks to another one of said common channel signalling networks a signal unit comprising user data, an originating office code, and a destination office code and each of said common channel signalling networks including:

   an originating office including means for setting the user data, the originating office code and the destination office code in the signal unit and means for sending the signal unit to the gateway office in said one of said common channel signalling networks, the gateway office in said one of said common channel signalling networks including:

first changing means for changing in accordance with the user data the destination office code in the signal unit received from said signalling office in said common channel signalling network to which said gateway office belongs, to a gateway office code of said another common channel signalling network which is a second destination office code, and changing the originating office code from said originating office code of said signalling office to an own gateway office code, and for transmitting the signal unit including the second destination information through said local signalling network including both gateway offices; and the gateway office in said another of said common channel signalling networks including:

second changing means for changing, in accordance with the user data, the destination office code in a signal unit received from said gateway office in said local signalling office to which said gateway office belongs, to the destination office code which is a third destination office, for changing the originating office code from said gateway office code to an own gateway office code, and for transmitting the signal unit including the third destination information to the destination office.

## Revendications

1. Système de connexion entre réseaux pour l'interconnexion d'une pluralité de réseaux de signalisation à canal commun utilisant un système de signalisation sur canal commun, ledit système de connexion comprenant :

une pluralité de réseaux de signalisation à canal commun (A, B), chacun comportant un système de codage indépendant (système de numérotation basé sur un plan de numérotation) dans laquelle chacun des réseaux de signalisation à canal commun comporte un ou plusieurs centraux de signalisation et, dans chacun desdits réseaux de signalisation à canal commun, l'un desdits centraux de signalisation est connecté pour fonctionner comme central passerelle ; et

un réseau de signalisation locale (C) comprenant un système point à point comprenant au moins un central passerelle de chacun desdits réseaux de signalisation à canal commun et comprenant, dans chacun desdits réseaux de signalisation locale un système de codage (système de numérotation basé sur un plan de numérotation) qui est différent de celui de chacun desdits réseaux de signalisation à canal commun, chacun desdits centraux de signalisation comprenant :

des moyens pour transmettre de l'un desdits réseaux de signalisation à canal commun à l'un des autres dits réseaux de signalisation à canal commun, une unité de signal comprenant des données utilisateur, un code de central d'origine, et un code de central destinataire, et chacun desdits réseaux de signalisation à canal commun comprenant :

un central d'origine comprenant des moyens pour établir les données utilisateur, le code du central d'origine, et le code du central de destination dans l'unité de signal et des moyens pour émettre l'unité de signal vers le central passerelle dans l'un desdits réseaux de signalisation à canal commun, le central passerelle dans l'un des dits réseaux de signalisation à canal commun comprenant :

des premiers moyens de commutation pour changer, en fonction des données utilisateur, le code du central de destination dans l'unité de signal reçue dudit central de signalisation dans ledit réseau de signalisation à canal commun auquel appartient ledit central passerelle, en un code de central passerelle d'un dit autre réseau de signalisation à canal commun, qui est un second code de central de destination, et pour changer le code de central d'origine dudit code de central d'origine dudit central de signalisation en un code propre de central passerelle, et pour transmettre l'unité de signal comprenant la seconde information de destination sur le réseau de signalisation local comprenant les deux centraux passerelles ; et le central passerelle dans un autre desdits réseaux de signalisation à canal commun comprenant :

des seconds moyens de commutation pour, changer, en fonction des données utilisateur, le code du central de destination dans une unité de signal reçu provenant dudit central passerelle dans ledit central de signalisation locale auquel ledit central passerelle appartient, en un code de central de destination qui est le troisième central de destination, pour changer le code de central d'origine dudit code de central passerelle en un code propre de central passerelle et pour transmettre l'unité de signal comprenant la troisième information de destination vers le central de destination.

**Ansprüche**

1. Verbindungssystem zwischen Netzwerken für die Verbindung einer Vielzahl von Übermittlungsnetzwerken mit gemeinsamem Kanal, die ein Übermittlungssystem mit gemeinsamem Kanal verwenden, wobei das Verbindungssystem umfaßt:

   eine Vielzahl von Übermittlungsnetzwerken (A,B) mit gemeinsamem Kanal, die jeweils ein unabhängiges Kodierungssystem (Numerierungssystem basierend auf einem Numerierungsplan) besitzen, worin jedes der Übermittlungsnetzwerke mit gemeinsamem Kanal ein oder mehrere Übermittlungsämter umfaßt und in jedem der Übermittlungsnetzwerke mit gemeinsamem Kanal eines der Übermittlungsämter angeschlossen ist, um als Gateway-Amt zu arbeiten; und

   ein lokales Übermittlungsnetzwerk (C), das ein Punkt-zu-Punkt-System, das zumindest ein Gateway-Amt von jedem der Übermittlungsnetzwerke mit gemeinsamem Kanal einschließt, und in jedem lokalen Übermittlungsnetzwerk ein Kodierungssystem (Numerierungssystem basierend auf einem Numerierungsplan) umfaßt, das von dem eines jeden der Übermittlungsnetzwerke gemeinsamem Kanal unterschiedlich ist, wobei jedes der Übermittlungsämter umfaßt:

   eine Einrichtung zur Übertragung einer Signaleinheit, die Benutzerdaten, eine Ursprungsamtcodierung und eine Bestimmungsamtcodierung umfaßt von einem der Übermittlungsnetzwerke mit gemeinsamem Kanal und jedes der Übertragungsnetzwerke mit gemeinsamem Kanal umfaßt:

   ein Ursprungsamt, das eine Einrichtung für die Einstellung der Benutzerdaten, der Ursprungsamtcodierung und der Bestimmungsamtcodierung in der Signaleinheit und eine Einrichtung für das Senden der Signaleinheit zum Gateway-Amt in einem der Übermittlungsnetzwerke mit gemeinsamem Kanal umfaßt, wobei das Gateway-Amt in einem der Übertragungsnetzwerke mit gemeinsamem Kanal umfaßt:

   eine erste Austauscheinrichtung zum Austausch in Übereinstimmung mit den Benutzerdaten der Bestimmungsamtcodierung in der Signaleinheit, die von dem übermittelnden Amt in dem Übermittlungsnetzwerk mit gemeinsamem Kanal empfangen wird, zu dem das Gateway-Amt gehört, mit einer Gateway-Amtcodierung des anderen Übermittlungsnetzwerkes mit gemeinsamem Kanal, die eine zweite Bestimmungsamtcodierung ist, und zum Austausch der Ursprungsamtcodierung von der Ursprungsamtcodierung des übermittelnden Amtes mit einer eigenen Gateway-Amtcodierung, und zur Übertragung der Signaleinheit, die die zweite Bestimmungsinformation enthält, über das lokale Übermittlungsnetzwerk, das beide Gateway-Ämter einschließt; und wobei das Gateway-Amt in dem anderen der übermittlungsnetzwerke mit gemeinsamem Kanal umfaßt:

   eine zweite Austauscheinrichtung zum Austausch in Übereinstimmung mit den Benutzerdaten der Bestimmungsamtcodierung in einer Signaleinheit, die von dem Gateway-Amt in dem lokalen Übermittlungsamt, zu dem das Gateway-Amt gehört, empfangen wird, mit der Bestimmungsamtcodierung, das ein drittes Bestimmungsamt ist, zum Austausch der Ursprungsamtcodierung von der Gateway-Amtcodierung mit einer eigenen Gateway-Amtcodierung, und zur Übertragung der Signaleinheit, die die dritte Bestimmungsinformation enthält, zu dem Bestimmungsamt.

# Fig. 1

| UDATA | OPC 1i | DPC 1 | → | UDATA | OPC 10 | DPC 20 | → | UDATA | OPC 2 | DPC 2i | → |

# Fig.2

# Fig. 3

CONTROL DATA PART
44

| CONTROL DATA PART |
|---|
| SIGNAL LINK ROUTE TRANSLATION TABLE |
| TRANSACTION |
| SIGNAL NETWORK ATTRIBUTE ADMINISTRATION DATA |

**CSE**

| SIGNAL RECEPTION CONTROLLING PART | SIGNAL TRANSMISSION CONTROLLING PART |
|---|---|

41
L2

| SIGNAL RECEPTION PROCESSING PART | SIGNAL TRANSMISSION PROCESSING PART |
|---|---|

42
L3

**USER PART**

43
L4

CONTROL PROGRAM CP

EP 0 203 614 B1

# Fig. 4

| CK | UDATA | OPC | DPC | UI | L2H |
|----|-------|-----|-----|----|----|

TRANSMISSION SEQUENCE

SIGNAL UNIT FORMAT

L2H ⋯ LEVEL 2 HEADER

UI ⋯ USER IDENTIFIER

DPC ⋯ DESTINATION OFFICE CODE

OPC ⋯ ORIGINATING OFFICE CODE

UDATA ⋯ USER DATA

CK ⋯ SIGNAL UNIT TRANSMISSION ERROR CHECK FLAG

EP 0 203 614 B1

## Fig. 5

SIGNAL TERMINAL NUMBER

LSN

SIGNAL LINK ROUTE NUMBER
TRANSLATION TABLE

LSN⋯ SIGNAL LINK ROUTE NUMBER

## Fig. 6

n x
LSN

NID
NAT
SSPC

SIGNAL LINK ROUTE- SIGNALING
NETWORK ATTRIBUTE TRANSLATION TABLE

NID⋯ SIGNALING NETWORK IDENTIFIER
NAT⋯ SIGNALING NETWORK ATTRIBUTE
SSPC⋯ SELF OFFICE CODE

## Fig.7

USER DATA- SIGNALING NETWORK IDENTIFIER
TRANSLATION TABLE

NID⋯ SIGNALING NETWORK IDENTIFIER
DPC⋯ DESTINATION OFFICE CODE
OPC⋯ ORIGINATING OFFICE CODE

## Fig. 8

SIGNALING NETWORK IDENTIFIER- SIGNAL
ROUTE TRANSLATION TABLE

NID ⋯ SIGNALING NETWORK IDENTIFIER
NAT ⋯ SIGNALING NETWORK ATTRIBUTE
LSN ⋯ SIGNAL LINK ROUTE NUMBER

SIGNAL LINK
ROUTE NUMBER

ROUTING TABLE

# Fig. 9

EP 0 203 614 B1

## Fig. 10A

Fig. 10

| Fig.10A | Fig.10 B |
|---------|----------|
| Fig.10 C | |

( SIGNAL RECEPTION PROCESS )(LEVEL 3)

S1 — TRANSLATE SIGNAL TERMINAL NUMBER SUCCEEDED FROM COMMON CHANNEL SIGNALING EQUIPMENT CONTROLLER INTO SIGNAL LINK ROUTE NUMBER (LSN)

S2 — OBTAIN NETWORK IDENTIFIER (NID), NETWORK ATTRIBUTE (NAT), AND SELF OFFICE CODE (SSPC) FROM SIGNAL LINK ROUTE NUMBER

S3 — COMPARE DESTINATION OFFICE CODE (DPC) OF RECEIVED SIGNAL AND SELF OFFICE CODE (SSPC) OBTAINED AT STEP S2

EP 0 203 614 B1

# Fig. 10 B

RECEIVING TRANSACTION

| |
|---|
| SIGNAL TERMINAL NUMBER |
| RECEIVED SIGNAL |

SIGNAL LINK ROUTE NUMBER
TRANSLATION TABLE

| |
|---|
| LSN |
| |

SIGNAL LINK ROUTE-SIGNALING
NETWORK ATTRIBUTE TRANSLATION TABLE

n x LSN

| |
|---|
| NID |
| NAT |
| SSPC |

RECEIVING TRANSACTION

| |
|---|
| DPC |
| |

RECEIVED SIGNAL

# Fig. lO C

S4 — RECEPTION TO OWN OFFICE ? 

NO (NO-CORRESPONDENCE)

S7 — CARRY OUT PROCESS ACCORDING TO SIGNALLING NETWORK ATTRIBUTE (NAT)

YES (CORRESPONDENCE)

S5 — SET NETWORK IDENTIFIER (NID) OBTAINED AT STEP S2 IN TRANSACTION AS SUCCESSIVE INFORMATION TO USER PART

RECEIVING TRANSACTION

NID

SIGNAL

S6 — DISTINGUSH USER IDENTIFIER (UI) OF RECEIVED SIGNAL

USER SIGNAL ?

NETWORK CONTROL SIGNAL

S8 — NETWORK ADMINISTRATION

USER SIGNAL

USER PART (LEVEL 4)

EP 0 203 614 B1

## Fig. 11A

Fig.11

| Fig.11A | Fig.11B |

( USER PART INTER-NETWORK CONNECTION PROCESS )(LEVEL 4 )

ANALYZE USER DATA OF RECEIVED SIGNAL, THEN OBTAIN NETWORK IDENTIFIER ( NID ), ORIGINATING OFFICE CODE (OPC ), AND DESTINATION OFFICE CODE (DPC) OF THE SIGNALING NETWORK TO WHICH SPEECH PATH IS TO BE SET FROM TABLE  ∼ S11

SET SPEECH PATH FOR SIGNAL ORIGINATED OFFICE ON BASIS OF NETWORK IDENTIFIER ( NID ) OF SIGNAL ORIGINATED OFFICE, ORIGINATING OFFICE CODE (OPC ) AND USER DATA CONTAINED IN THE RECEIVED SIGNALS  ∼ S12

RE-EDITE SIGNAL UNIT CONTAINING (OPC) AND (DPC) OBTAINED BY THE ANALYSIS AT STEP S11, AND DEMAND SIGNAL TRANSMISSION FOR LEVEL 3 BY INDICATING(NID)  ∼ S13

( SIGNAL TRANSMISSION PROCESSING PART )(LEVEL 3 )

EP 0 203 614 B1

# Fig. 11B

RECEIVING TRANSACTION

USER DATA-SIGNALING
NETWORK IDENTIFIER
TRANSLATION TABLE

USER DATA — RECEIVED SIGNAL

NID
DPC
OPC

RECEIVING TRANSACTION

NID
OPC
USER DATA — RECEIVED SIGNAL

TRANSMISSION TRANSACTION

NID
DPC
OPC
USER DATA — TRANSMISSION SIGNAL

EP 0 203 614 B1

# Fig. 12 A

( SIGNAL TRANSMISSION PROCESS ) (LEVEL 3)

OBTAIN NETWORK ATTRIBUTE (NAT) AND SIGNAL LINK ROUTE NUMBER (LSN) FROM NETWORK IDENTIFIER (NID) SUCCEEDED FROM USER PART BY TRANSLATING NETWORK IDENTIFIER SIGNAL LINK ROUTE TRANSLATION TABLE

S21

S22

BRANCH ACCORDING TO (NAT)

POINT TO POINT TYPE
SIGNALING NETWORK (C)

S 23

SELECT SIGNAL LINK WITHIN (LSN) OBTAINED AT STEP S21

( COMMON CHANNEL SIGNALING EQUIPMENT CONTROL PROGRAM )

EP 0 203 614 B1

# Fig. 12B

SIGNAL NETWORK IDENTIFIER-SIGNAL LINK ROUTE TRANSLATION TABLE

TRANSMISSION TRANSACTION

| NAT |
|-----|
| LSN |

NID | SIGNAL

ANOTHER SIGNALING NETWORK (A,B)

ROUTING ACCORDING TO SIGNAL NETWORK ATTRIBUTE

S24

COMMON CHANNEL SIGNALING EQUIPMENT CONTROL PROGRAM

## Fig. 13

## Fig. 14

# Fig. 15

# Fig. 16

A. B ⋯ SIGNALING NETWORK

1. 2 ⋯ GATEWAY OFFICE

⟨⟩⋯ SIGNALING NETWORK BEFORE INTERCONNECTION

⟨⟩⋯ SIGNALING NETWORK AFTER INTERCONNECTION

# Fig. 17

DATA COMMUNICATION PATH

SPEECH PATH

COMMON CHANNEL SIGNAL LINK

1 ,1i,1j,2 ,2i,2j ⋯ SIGNALING OFFICE

O1,O2,O3,O4 ⋯⋯⋯ TELEPHONE OFFICE

O5,O6, O7, O8 ⋯⋯⋯ DATA COMMUNICATION OFFICE

EP 0 203 614 B1